# EUROPEAN PATENT APPLICATION

(11) **EP 0 522 388 A1**
(43) Date of publication of application: **13.01.1993**
(21) Application number: 92110931.0
(22) Date of filing: 27.06.1992
(51) Int. Cl.: H03H 2/00, H01F 10/24, H01F 10/28

(54) **Magnetostatic-wave devices**

(30) Priority: 01.07.1991 JP 188213/91; 01.07.1991 JP 188215/91; 01.07.1991 JP 188216/91; 01.07.1991 JP 188217/91; 01.07.1991 JP 188218/91; 01.07.1991 JP 188219/91
(71) Applicant: MURATA MANUFACTURING CO., LTD., Nagaokakyo-shi Kyoto-fu 226 (JP)
(72) Inventor: Aota, Mitsuhiro, Nagaokakyo-shi, Kyoto-fu (JP); Fujino, Masaru, Takatsuki-shi, Osaka-fu (JP); Mizuno, Shinobu, Nagaokakyo-shi, Kyoto-fu (JP); Kumatoriya, Makoto, Nagaokakyo-shi, Kyoto-fu (JP); Takagi, Hiroshi, Ohtsu-shi, Shiga-ken (JP)
(74) Representative: von Kreisler, Alek, Dipl.-Chem.

(57) **Abstract**

A magnetostatic wave device comprises a magnetic garnet film epitaxially grown on a Gd₃Ga₂(GaO₄)₃ substrate. The film is of a composition of a system (Y,Gd)₃Fe₅O₁₂ and has the lattice constant substantially equal to that of the substrate, the difference in lattice constant between the substrate and film being not more than 0.01 Å. The composition may be modified with a small amount of at least one element selected from the group consisting of Bi, Ga and Al.

## Description

### BACKGROUND OF THE INVENTION

### 1. Field of the Invention

The present invention relates to a magnetostatic-wave device and, more particularly, a magnetostatic wave devices comprising a magnetic garnet film formed on a substrate of gadolinium-gallium-garnet.
chemical formula Y₃Fe₂(FeO₄)₃, of the chemical formula Gd₃Ga₂(GaO₄)₃.

### 2. Description of the Prior Art

Recently, there have been proposed various kinds of magnetostatic wave (MSW) devices such as MSW filters, MSW delay lines, and the like. Such magnetostatic wave devices generally comprises a yttrium-iron-garnet (YIG) film grown by liquid-phase epitaxy on a gadolinium-gallium-garnet (GGG) substrate. The epitaxially grown YIG films make it possible to reduce a difference between input and output signals of the MSW devices because of their very small magnetic resonance half linewidth (ΔH).

However, the saturation magnetization (4πMₛ) of the YIG film varies greatly with temperature and the temperature coefficient of 4πMₛ is of the order of about 2100 ppm/°C. It is therefore required to choose a permanent magnet with a suitable temperature coefficient of magnetic field to produce the MSW devices with good temperature characteristics. It is, however, difficult to produce MSW devices with a desired temperature characteristics because of limited kinds of permanent magnet materials.

### SUMMARY OF THE INVENTION

It is therefore an object of the present invention to provide a magnetostatic-wave device with excellent temperature characteristics.

Another object of the present invention is to provide a magnetic garnet material for magnetostatic wave devices with a controlled temperature coefficient of saturation magnetization (4πMₛ), without increasing the magnetic resonance half linewidth (ΔH).

According to the present invention there is provided a magnetostatic wave device comprising magnetic garnet film formed on a substrate of Gd₃Ga₂(GaO₄)₃, characterized in that said magnetic garnet film is made of a composition of a system (Y,Gd)₃Fe₂(FeO₄)₃ or (Y,Gd)₃Fe₅O₁₂ and has the lattice constant close to that of the substrate, the difference in lattice constant between said substrate and film being not more than 0.01 Å.

The composition of a (Y,Gd)₃Fe₅O₁₂ system as a material for magnetic garnet films of the present invention may be modified by replacing a part of Fe with Ga and/or Al or by replacing a part of Y with Bi.

According to the present invention, there is provided a material for the magnetic garnet films which has a composition expressed by the general formula (I):

Y_{3-x-y}GdₓBi_{y}Fe₅₋ₘ₋ₙGaₘAlₙO₁₂ (I)

where x, y, m and n are mole fractions of the respective ingredients and take respective values falling in the following ranges: 0 < x ≦ 1, 0 ≦ y ≦ 1, 0 ≦ x + y ≦ 1, 0 ≦ m ≦ 1, 0 ≦ n ≦ 1, and 0 ≦ m + n ≦ 1.

In a preferred embodiment of present invention, a magnetostatic wave device comprises a magnetic garnet film of a composition of the general formula (II):

Y₃₋ₓGdₓFe₅₋ₘGaₘO₁₂ (II)

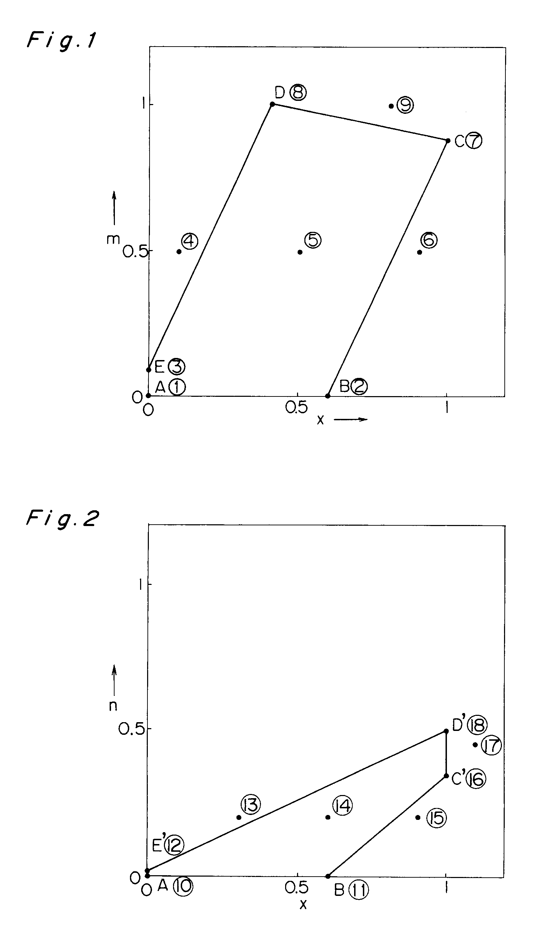

where x and m are mole fractions of Gd and Ga and respectively take a value in the following ranges: 0 < x ≦ 1.00, 0 < m ≦ 1.00. Preferably, the composition of the general formula (II) has a set of x and m falling in the area encompassed by a polygon ABCDE defined by points A (0, 0), B (0.6, 0), C (1, 0.88), D (0.41, 1) and E (0, 0.09) in a compositional diagram shown in Fig. 1 with x as abscissa and m as ordinate, except for a set of x and m falling on the side AE of the polygon.

In another preferred embodiment of the present invention, a magnetostatic wave device comprises a magnetic garnet film of a composition expressed by the general formula (III):

Y₃₋ₓGdₓFe₅₋ₙAlₙO₁₂ (III)

where x and n are mole fractions of Gd and Al and respectively take a value in the following ranges: 0 < x ≦ 1, and 0 ≦ n ≦ 0.49. In this case, it is preferred that the composition of the general formula (III) has a set of x and n falling in the area encompassed by a polygon ABC'D'E' defined by points A (0, 0), B (0.60, 0), C' (1.00, 0.34), D' (1.00, 0.49) and E' (0, 0.02) in a compositional diagram shown in Fig. 2 with x as abscissa and n as ordinate, except for a set of x and n falling on the side AE' of the polygon.

In another preferred embodiment of the present invention there is provided a magnetostatic wave device comprising a magnetic garnet film of a composition expressed by the general formula (IV):

Y₃₋ₓGdₓFe₅₋ₘ₋ₙGaₘAlₙO₁₂ (IV)

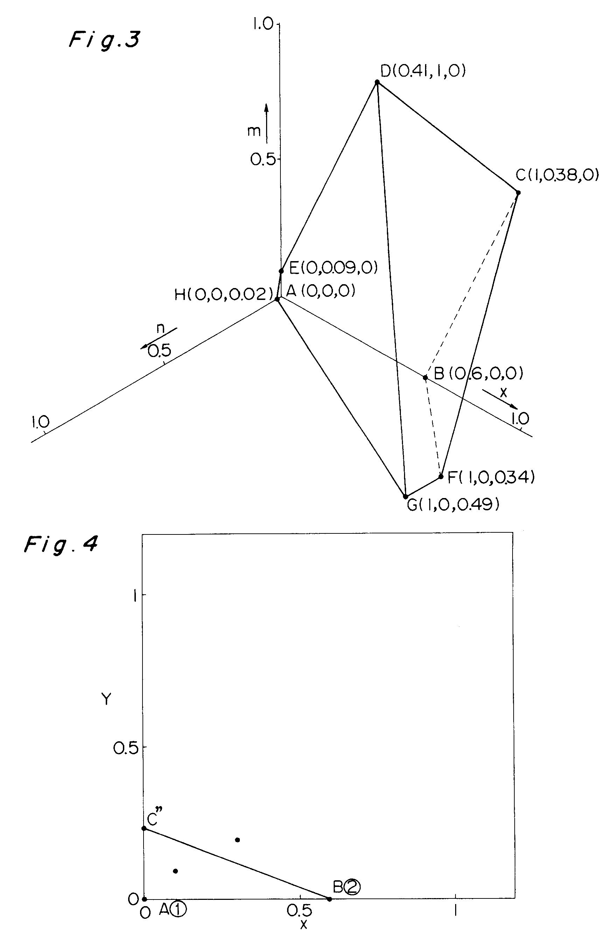

where x, m and n are mole fractions of Gd, Ga and Al and respectively take a value in the following ranges: 0 < x ≦ 1, 0 ≦ m ≦ 1, and 0 ≦ n ≦ 0.49. In this case, it is preferred that the composition of the general formula (IV) has a set of x, m and n falling in the area encompassed by a polyhedron ABCDEFGH defined by points A (0, 0, 0), B (0.6, 0, 0), C (1, 0.88, 0), D (0.41, 1, 0), E (0, 0.09, 0), F (1, 0, 0.34), G (1, 0, 0.49) and H (0, 0, 0.02) in a compositional diagram of the Cartesian coordinate system shown in Fig. 3.

In a further embodiment of the present invention, a magnetostatic wave device comprises a magnetic garnet film of a composition expressed by the general formula (V):

Y_{3-x-y}GdₓBi_{y}Fe₅O₁₂ (V)

where x and y are mole fractions of Gd and Bi and respectively take a value in the following ranges: 0 < x ≦ 1, 0 ≦ y ≦ 1, 0 < x + y ≦ 1. In this case, it is preferred that the composition of the general formula (V) has a set of x and y falling within the area encompassed by a polygon ABC defined by points A (0, 0), B (0.6, 0), C (0, 0.23) in a compositional diagram shown in Fig. 4 with x as abscissa and y as ordinate, except for a set of x and y falling on the side AC of the polygon ABC.

In still another embodiment of the present invention, a magnetostatic wave device comprises a magnetic garnet film made of a composition expressed by the general formula (VI):

Y_{3-x-y}GdₓBi_{y}Fe₅₋ₘGaₘO₁₂ (VI)

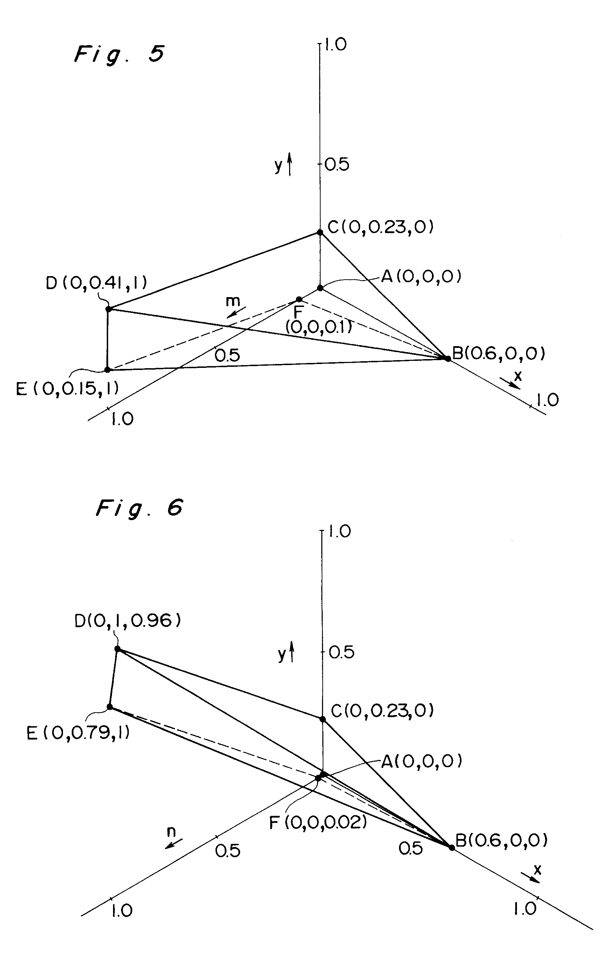

where x, y and m are mole fractions of Gd, Bi and Ga and respectively take a value in the following ranges: 0 < x ≦ 1, 0 ≦ y ≦ 1, 0 < x + y ≦ 1, and 0 ≦ m ≦ 1. In this case, it is preferred that the composition of the general formula (VI) has a set of x, y and m falling in the area encompassed by a polyhedron ABCDEF defined by points A (0, 0, 0), B (0.6, 0, 0), C (0, 0.23, 0), D (0, 0.41, 1), E (0, 0.15, 1) and F (0, 0, 0.10) in a compositional diagram of the Cartesian coordinate system shown in Fig. 5.

In another preferred embodiment of the present invention, a magnetostatic wave device comprises a magnetic garnet film of a composition expressed by the general formula (VII):

Y_{3-x-y}GdₓBi_{y}Fe₅₋ₙAlₙO₁₂ (VII)

where x, y and n are mole fractions of Gd, Bi and Al and take a value in the following respective ranges: 0 < x ≦ 1, 0 ≦ y ≦ 1, 0 < x + y ≦ 1, and 0 ≦ n ≦ 1. It is, however, preferred that the composition of the general formula (VII) has a set of x, y and n falling in the area encompassed by a polyhedron ABCDEF defined by points A (0, 0, 0), B (0.6, 0, 0), C (0, 0.23, 0), D (0, 1, 0.96), E (0, 0.79, 1) and F (0, 0, 0.02) in a compositional diagram of the Cartesian coordinate system shown in Fig. 6.

The magnetostatic wave device of the present invention possesses excellent temperature characteristics as the magnetic garnet film may have a desired temperature coefficient of saturation magnetization ranging from about 550 to about 2200 ppm/°C, without causing increase in the magnetic resonance half linewidth (ΔH). Also the magnetostatic wave device of the present invention have good quality as the difference in lattice constant between the magnetic garnet film and Gd₃Ga₅O₁₂ substrate is minimized to not more than 0.01 Å.

The above and other objects, features and advantages of the present invention will be apparent from the following explanation with reference to several examples thereof.

### BRIEF DESCRIPTION OF THE DRAWINGS

Fig. 1 is a compositional diagram representing the area of compositions of a Y₃₋ₓGdₓFe₅₋ₘGaₘO₁₂ system used in the present invention;
Fig 2 is a compositional diagram representing the area of compositions of a Y₃₋ₓGdₓFe₅₋ₙAlₙO₁₂ system used in the present invention;
Fig. 3 is a compositional diagram by the Cartesian coordinate system, representing the area of compositions of a Y₃₋ₓGdₓFe₅₋ₘ₋ₙGaₘAlₙO₁₂ system used in the present invention;
Fig 4 is a compositional diagram representing the area of compositions of a Y_{3-x-y}GdₓBi_{y}Fe₅O₁₂ system used in the present invention;
Fig. 5 is a compositional diagram similar to Fig. 3, representing the area of compositions of a Y_{3-x-y}GdₓBi_{y}-Fe₅₋ₘGaₘO₁₂ system used in the present invention; and
Fig. 6 is a compositional diagram similar to Fig. 3, representing the area of compositions of a Y_{3-x-y}GdₓBi_{y}-Fe₅₋ₙAlₙO₁₂ system used in the present invention.

### Example 1

Using the liquid-phase epitaxy (LPE), magnetic garnet films were deposited on Gd₃Ga₅O₁₂ substrates (hereinafter referred to as "GGG substrate) in the following manner.

Powdered materials of Fe₂O₃, Y₂O₃, Gd₂O₃ and Ga₂O₃ were weighed and mixed so that the product has a composition of the general formula (II): Y₃₋ₓGdₓFe₅₋ₘGaₘO₁₂_{,} with a set of x and M shown in Table 1. The resultant mixture was added with a suitable amount of a solvent composed of PbO and B₂O₃, put into a platinum crucible, and then heated to 1200 °C with a vertical electric furnace to prepare a homogeneous melt.

The melt was then cooled to about 900 °C and kept at that temperature to make the garnet into a supersaturated state. Then, the GGG substrate was immersed in the melt and rotated therein for a certain period of time to allow the composition to epitaxially grown on the GGG substrate. The substrate was then drawn up from the melt and rotated at a high rate of revolution to remove the melt from the epitaxially grown garnet film on the substrate.

The thus produced specimens were subjected to measurements of the lattice constant, saturation magnetization (4πMₛ), temperature coefficient (TC) of 4πMₛ, and magnetic resonance half linewidth (ΔH). The lattice constant was determined by the X-ray diffraction, while the saturation magnetization (4πMₛ) and the magnetic resonance half linewidth (ΔH) were measured with an electron spin resonance (ESR) spectroscopy. Results are shown in Table 1. In this table, specimens with an asterisk (*) are those out of the scope of the present invention.

Also, the compositions of the specimens are plotted in a compositional of Fig. 1 with x as abscissa and m as ordinate, along with the area of composition falling within the scope of the present invention. The numbers in Fig. 1 correspond to the respective specimen numbers. The compositions having a set of x and m falling in the area encompassed by a polygon ABCDE are those falling in the scope of the present invention. The sets of x and m at vertices of the polygon are as follows: A (0, 0), B (0.6, 0), C (1, 0.88), D (0.41, 1) and E (0, 0.09).

**Table 1**

| No. | x | m | 4πMₛ (G) | ΔH (Oe) | TC of 4πMₛ (ppm/°C) | lattice constant (Å) |
|---|---|---|---|---|---|---|
| 1* | 0 | 0 | 1800 | 0.6 | -2100 | 12.376 |
| 2 | 0.60 | 0 | 1380 | 2.7 | -1500 | 12.393 |
| 3 | 0 | 0.09 | 1500 | 0.9 | -2200 | 12.373 |
| 4* | 0.10 | 0.5 | Good films were never obtained | | | |
| 5 | 0.5 | 0.5 | 1250 | 1.7 | -1800 | 12.382 |
| 6* | 0.9 | 0.5 | Good films were never obtained | | | |
| 7 | 1 | 0.88 | 830 | 2.4 | -1700 | 12.393 |
| 8 | 0.41 | 1.00 | 680 | 1.9 | -2100 | 12.373 |
| 9* | 0.8 | 1.00 | 590 | 5.6 | -1900 | 12.385 |

The compositions of a Y₃₋ₓGdₓFe₅₋ₘGaₘO₁₂ system for magnetic garnet films have been limited to those falling on or within the polygon for the following reasons.

If the composition has a set of x and m falling in an area out of a line BC or DE of the polygon (e.g., specimen No. 4 and 6), it is impossible to produce magnetic garnet films with good quality as the difference in lattice constant between the film and the GGG substrate becomes greater than 0.01 Å, which in turn causes cracking of the magnetic garnet film.

Further, if the composition has a set of x and m falling on a point out of the line CD of the polygon (e.g., specimen No.9), the magnetic resonance half linewidth (ΔH) becomes greater than 5 Öe, thus making it impossible to use the magnetic garnet films for the magnetostatic wave devices.

As can be seen from the data for specimen No. 1, this composition is YIG and possesses a large temperature coefficient of the saturation magnetization (4πMₛ). The composition with x = 0 and y = 0 is of course excluded from the scope of the present invention.

### Example 2

Powdered materials of Fe₂O₃, Y₂O₃, Gd₂O₃ and Al₂O₃ were weighed and mixed so that the resultant mixture has a composition of a system Y₃₋ₓGdₓFe₅₋ₙAlₙO₁₂ with a set of x and n shown in Table 2. Using each resultant mixture, there was prepared specimens comprising a magnetic garnet film deposited on a GGG substrate by the liquid-phase epitaxy in the same manner as Example 1.

For each specimen, measurements were made on the lattice constant, saturation magnetization (4πMₛ), temperature coefficient (TC) of 4πMₛ, and magnetic resonance half linewidth (ΔH) of the magnetic garnet film. Results are shown in Table 2. In this table, the specimens with an asterisk (*) are those having a composition out of the scope of the present invention.

The compositions of the resultant garnet films are plotted in a compositional of Fig. 2 with x as abscissa and n as ordinate, along with the area of the composition falling in the scope of the present invention. The numbers in Fig. 2 correspond to the respective specimen numbers. The compositions each having a set of x and n falling in the area encompassed by a polygon ABCDE are those included in the scope of the present invention. The sets of x and n at vertices of the polygon are as follows: A (0, 0), B (0.60, 0), C' (1.00, 0.34), D' (1.00, 0.49) and E' (0, 0.02).

**Table 2**

| No. | x | n | 4πMₛ (G) | ΔH (Oe) | TC of 4πMₛ (ppm/°C) | lattice constant (Å) |
|---|---|---|---|---|---|---|
| 10* | 0 | 0 | 1800 | 0.6 | -2100 | 12.376 |
| 11 | 0.60 | 0 | 1380 | 2.7 | -1500 | 12.393 |
| 12 | 0 | 0.02 | 1700 | 0.9 | -2200 | 12.373 |
| 13* | 0.30 | 0.2 | Good films were never obtained | | | |
| 14 | 0.6 | 0.2 | 1080 | 1.8 | -1300 | 12.382 |
| 15* | 0.9 | 0.2 | Good films were never obtained | | | |
| 16 | 1 | 0.34 | 680 | 2.7 | -900 | 12.393 |
| 17* | 1.1 | 0.45 | 500 | 6.4 | -700 | 12.383 |
| 18 | 1 | 0.49 | 550 | 2.9 | -800 | 12.373 |

As will be understood from the data for specimens No. 13 and 15, if the composition has a set of x and n falling in an area out of the line BC or the line DE of the polygon, the difference in the lattice constant between the GGG substrate and magnetic garnet film becomes more than 0.01 Å, which in turn causes cracking of the magnetic garnet film, thus making it impossible to produce magnetic garnet films with good quality.

Further, as can be seen from the data for specimen No. 17, if the composition has a set of x and n falling in an area out of the line CD of the polygon, the magnetic resonance half linewidth (ΔH) becomes more than 5 Öe, thus making it impossible to use it as a material for magnetic garnet films in the magnetostatic wave devices.

For the reasons mentioned above, the composition of the Y₃₋ₓGdₓFe₅₋ₙAlₙO₁₂ system has been limited to those having a set of x and n falling on or within the area encompassed by the polygon ABCDE defined by the points A (0, 0), B (0.6 , 0), C (1, 0.34), D (1, 0.49) and E (0, 0.02) in Fig. 2. However, the composition having a set of x and n falling on the point A is excluded from the scope of the present invention.

### Example 3

Powdered materials of Fe₂O₃, Y₂O₃, Gd₂O₃, Al₂O₃ and Ga₂O₃ were weighed and mixed so as to prepare a composition of the general formula: Y₃₋ₓGdₓFe₅₋ₘ₋ₙGaₘAlₙO₁₂ with a set of x, m and n shown in Table 3. Using each of the resultant mixtures, there were prepared specimens comprising a magnetic garnet film deposited on a GGG substrate by the liquid-phase epitaxy in the same manner as Example 1.

For each specimen, measurements were made on the lattice constant, saturation magnetization (4πMₛ), temperature coefficient (TC) of 4πMₛ, and magnetic resonance half linewidth (ΔH) of the magnetic garnet film. Results are shown in Table 3. In this table, the specimens with an asterisk (*) are those having a composition out of the scope of the present invention.

**Table 3**

| No. | x | m | n | 4πMₛ (G) | ΔH (Oe) | TC of 4πMₛ (ppm/°C) | lattice constant (Å) |
|---|---|---|---|---|---|---|---|
| 19* | 0 | 0 | 0 | 1800 | 0.6 | -2100 | 12.376 |
| 20 | 0.6 | 0 | 0 | 1380 | 2.7 | -1500 | 12.393 |
| 21 | 0 | 0.09 | 0 | 1500 | 0.9 | -2200 | 12.373 |
| 22* | 0.1 | 0.5 | 0 | Good films were never obtained | | | |
| 23 | 0.5 | 0.5 | 0 | 1250 | 1.7 | -1800 | 12.382 |
| 24* | 0.9 | 0.5 | 0 | Good films were never obtained | | | |
| 25 | 0.5 | 0.4 | 0.2 | 1100 | 2.0 | -1500 | 12.382 |
| 26 | 1 | 0.88 | 0 | 830 | 2.4 | -1700 | 12.393 |
| 27 | 0.41 | 1 | 0 | 680 | 1.9 | -2100 | 12.373 |
| 28* | 0.8 | 1 | 0 | 590 | 5.6 | -1900 | 12.385 |
| 29 | 0 | 0 | 0.02 | 1700 | 0.9 | -2200 | 12.373 |
| 30* | 0.3 | 0 | 0.2 | Good films were never obtained | | | |
| 31 | 0.6 | 0 | 0.2 | 1080 | 1.8 | -1300 | 12.382 |
| 32* | 0.9 | 0 | 0.2 | Good films were never obtained | | | |
| 33 | 1 | 0 | 0.34 | 680 | 2.7 | -900 | 12.393 |
| 34* | 1.1 | 0 | 0.45 | 500 | 6.4 | -700 | 12.383 |
| 35 | 1 | 0 | 0.49 | 550 | 2.9 | -800 | 12.373 |

As can be seen from the data for specimens No. 22, 24, 30 and 32, if the composition has a set of x, m and n falling in the area out of the area defined by the points B,C and F or by the points D, E, G and F, the difference in lattice constant between the GGG substrate and the magnetic garnet film exceeds 0.01Å, which in turn causes cracking of the magnetic garnet film, thus making it impossible to obtain garnet films with good quality.

Further, as can be seen from the data for specimens No. 28 and 34, if the composition has a set of x, m and n falling in the area out of the area defined by the points D, C, F and G, the magnetic resonance half linewidth (ΔH) becomes more than 5 Oe, thus making it impossible to use it as a material for magnetic film in magnetostatic wave devices.

The composition with x = 0, m = 0 and n = 0 is of course excluded from the scope of the present invention.

For the reasons mentioned above, the composition of a system Y₃₋ₓGdₓFe₅₋ₘ₋ₙGaₘAlₙO₁₂ has been limited to those having a set of values of x, m and n falling within the area encompassed by a polygon ABC'D'E'FGH defined by points A (0, 0, 0), B (0.6, 0, 0), C' (1, 0.88, 0), D' (0.41, 1, 0), E' (0, 0.09, 0), F (1, 0, 0.34), G (1, 0, 0.49) and H (0, 0, 0.02) in a ternary phase diagram shown in Fig. 3.

### Example 4

Powdered materials of Fe₂O₃, Y₂O₃, Gd₂O₃ and Bi₂O₃ were weighed and mixed to prepare a composition of a system Y_{3-x-y}GdₓBi_{y}Fe₅O₁₂ with a set of values of x and y shown in Table 4. Using each of the resultant mixtures, there were prepared specimens comprising a magnetic garnet film deposited on a GGG substrate by the liquid-phase epitaxy in the same manner as Example 1.

For each specimen, measurements were made on the lattice constant, saturation magnetization (4πMₛ), temperature coefficient (TC) of 4πMₛ, and magnetic resonance half linewidth (ΔH) of the magnetic garnet film. Results are shown in Table 4. In this table, the specimens with an asterisk (*) are those having a composition out of the scope of the present invention.

**Table 4**

| No. | x | y | 4πMₛ (G) | ΔH (Oe) | TC of 4πMₛ (ppm/°C) | lattice constant (Å) |
|---|---|---|---|---|---|---|
| 36* | 0 | 0 | 1800 | 0.6 | -2100 | 12.376 |
| 37 | 0.6 | 0 | 1380 | 2.7 | -1500 | 12.393 |
| 38 | 0.1 | 0.1 | 1500 | 1.9 | -1400 | 12.384 |
| 39* | 0.3 | 0.2 | Good films were never obtained | | | |
| 40 | 0 | 0.23 | 1740 | 1.3 | -1300 | 12.393 |

As can be seen from the data for specimens No. 39, if the composition has a set of x and y falling in the area out of the line BC of polygon ABC in Fig. 4, the difference in lattice constant between the GGG substrate and the magnetic garnet film exceeds 0.01Å, which in turn causes cracking of the magnetic garnet film, thus making it impossible to obtain garnet films with good quality.

The composition falling on the point A is of course excluded from the scope of the present invention.

For the reasons mentioned above, the composition of a system Y_{3-x-y}GdₓBi_{y}Fe₅O₁₂ has been limited to those having a set of x and y falling within the area encompassed by the polygon ABC defined by points A (0, 0), B (0.6, 0), C (0, 0.23) in the compositional shown in Fig. 4 with x as abscissa and y as ordinate.

### Example 5

Powdered materials of Fe₂O₃, Y₂O₃, Gd₂O₃, Bi₂O₃ and Ga₂O₃ were weighed and mixed to prepare a composition of the general formula: Y₃₋ₓGdₓBi_{y}Fe₅₋ₘGaₘO₁₂ with a set of x, y and m shown in Table 5. Using each of the resultant mixtures, there were prepared specimens comprising a magnetic garnet film deposited on a GGG substrate by the liquid-phase epitaxy in the same manner as Example 1.

For each specimen, measurements were made on the lattice constant, saturation magnetization (4πMₛ), temperature coefficient (TC) of 4πMₛ, and magnetic resonance half linewidth (ΔH) of the magnetic garnet film. Results are shown in Table 3. In this table, the specimens with an asterisk (*) are those having a composition out of the scope of the present invention.

**Table 5**

| No. | x | y | m | 4πMₛ (G) | ΔH (Oe) | TC of 4πMₛ (ppm/°C) | lattice constant (Å) |
|---|---|---|---|---|---|---|---|
| 41* | 0 | 0 | 0 | 1800 | 0.6 | -2100 | 12.376 |
| 42 | 0.6 | 0 | 0 | 1380 | 2.7 | -1500 | 12.393 |
| 43 | 0.1 | 0.1 | 0 | 1500 | 1.9 | -1400 | 12.384 |
| 44 | 0.05 | 0.1 | 0.4 | 1200 | 2.1 | -1500 | 12.382 |
| 45* | 0.3 | 0.2 | 0 | Good films were never obtained | | | |
| 46 | 0 | 0.23 | 0 | 1740 | 1.3 | -1300 | 12.393 |
| 47 | 0 | 0 | 0.1 | 1500 | 0.9 | -2200 | 12.373 |
| 48* | 0 | 0 | 0.5 | Good | films | were never | obtained |
| 49 | 0 | 0.2 | 0.5 | 950 | 1.4 | -1700 | 12.381 |
| 50* | 0 | 0.4 | 0.5 | Good films were never obtained | | | |
| 51 | 0 | 0.15 | 1 | 680 | 2.0 | -2200 | 12.373 |
| 52 | 0 | 0.41 | 1 | 630 | 2.5 | -1500 | 12.393 |
| 53* | 0 | 0.3 | 1.1 | 570 | 5.5 | -1400 | 12.385 |

As can be seen from the data for specimens No. 45, 48 and 50, if the composition has a set of x, y and m falling in the area out of the area defined by the points B, C and D or by the points B, E and F, the difference in lattice constant between the GGG substrate and the magnetic garnet film exceeds 0.01Å, which in turn causes cracking of the magnetic garnet film, thus making it impossible to obtain garnet films with good quality.

Further, as can be seen from the data for specimen No. 53, if the composition has a set of x, y and m falling in the area out of the line DE of the polygon, the magnetic resonance half linewidth (ΔH) becomes more than 5 Oe, thus making it impossible to use it as a material for magnetic film in magnetostatic wave devices.

The composition with x = 0, m = 0 and n = 0 is of course excluded from the scope of the present invention.

For the reasons mentioned above, the composition of a system Y₃₋ₓGdₓBi_{y}Fe₅₋ₘGaₘO₁₂ has been limited to those having a set of values of x, y and m falling within the area encompassed by a polygon ABCDEF defined by points A (0, 0, 0), B (0.6, 0, 0), C (1, 0.23, 0), D (0, 0.41, 1), E (0, 0.15, 1), F (0, 0, 0.1) in a ternary phase diagram shown in Fig. 5.

### Example 6

Powdered materials of Fe₂O₃, Y₂O₃, Gd₂O₃, Bi₂O₃ and Al₂O₃ were weighed and mixed to prepare a composition of a system Y₃₋ₓGdₓBi_{y}Fe₅₋ₘGaₘO₁₂ with a set of x, y and n shown in Table 6. Using each of the resultant mixtures, there were prepared specimens comprising a magnetic garnet film deposited on a GGG substrate by the liquid-phase epitaxy in the same manner as Example 1.

For each specimen, measurements were made on the lattice constant, saturation magnetization (4πMₛ), temperature coefficient (TC) of 4πMₛ, and magnetic resonance half linewidth (ΔH) of the magnetic garnet film. Results are shown in Table 6. In this table, the specimens with an asterisk (*) are those having a composition out of the scope of the present invention.

**Table 6**

| No. | x | y | n | 4πMₛ (G) | ΔH (Oe) | TC of 4πMₛ (ppm/°C) | lattice constant (Å) |
|---|---|---|---|---|---|---|---|
| 54* | 0 | 0 | 0 | 1800 | 0.6 | -2100 | 12.376 |
| 55 | 0.6 | 0 | 0 | 1380 | 2.7 | -1500 | 12.393 |
| 56 | 0.1 | 0.1 | 0 | 1500 | 1.9 | -1400 | 12.384 |
| 57 | 0.05 | 0.4 | 0.5 | 1000 | 1.7 | -1200 | 12.381 |
| 58* | 0.3 | 0.2 | 0 | Good films were never obtained | | | |
| 59 | 0 | 0.23 | 0 | 1740 | 1.3 | -1300 | 12.393 |
| 60 | 0 | 0 | 0.02 | 1700 | 0.9 | -2200 | 12.373 |
| 61* | 0 | 0.3 | 0.5 | Good films were never obtained | | | |
| 62 | 0 | 0.5 | 0.5 | 530 | 1.2 | -1000 | 12.382 |
| 63* | 0 | 0.7 | 0.5 | Good films were never obtained | | | |
| 64 | 0 | 0.79 | 1 | 390 | 2.0 | -600 | 12.373 |
| 65 | 0 | 1 | 0.96 | 420 | 2.5 | -550 | 12.393 |
| 66* | 0 | 0.9 | 1.1 | 380 | 5.3 | - 530 | 12.375 |

As can be seen from the data for specimens No. 58, 61 and 63, if the composition has a set of x, y and n falling in the area out of the area defined by the points B, C and D or by the points B, E and F, the difference in lattice constant between the GGG substrate and the magnetic garnet film exceeds 0.01Å, which in turn causes cracking of the magnetic garnet film, thus making it impossible to obtain garnet films with good quality.

Further, as can be seen from the data for specimen No. 66, if the composition has a set of x, y and n falling in the area out of the line DE of the polygon, the magnetic resonance half linewidth (ΔH) becomes more than 5 Oe, thus making it impossible to use it as a material for magnetic film in magnetostatic wave devices.

The specimen No. 54 having a composition with x = 0, y = 0 and n = 0 is of course excluded from the scope of the present invention.

For the reasons mentioned above, the composition of a system Y₃₋ₓGdₓBi_{y}Fe₅₋ₙAlₙO₁₂ has been limited to those having a set of values of x, y and n falling within the area encompassed by a polygon ABCDEF defined by points A (0, 0, 0), B (0.6, 0, 0), C (1, 0.23, 0), D (0, 1, 0.96), E (0, 0.79, 1), F (0, 0, 0.02) in a ternary phase diagram shown in Fig. 6.

## Claims

1. A magnetostatic wave device comprising a magnetic garnet film deposited on a substrate of Gd₃Ga₂(GaO₄)₃, characterized in that said magnetic garnet film is of a composition of a system (Y,Gd)₃Fe₅O₁₂ and that the difference in lattice constant between said substrate and film is not more than 0.01 Å.

2. The magnetostatic wave device according to claim 1 wherein said magnetic garnet film is of a composition expressed by the general formula:
Y_{3-x-y}GdₓBi_{y}Fe₅₋ₘ₋ₙGaₘAlₙO₁₂ (I)
where x, y, m and n are mole fractions of the respective ingredients and take respective values falling in the following ranges: 0 < x ≦ 1, 0 ≦ y ≦ 1, 0 < x + y ≦ 1, 0 ≦ m ≦ 1, 0 ≦ n ≦ 1, 0 ≦ m + n ≦ 1.

3. The magnetostatic wave device according to claim 2 wherein said magnetic garnet film is of a composition of the general formula:
Y₃₋ₓGdₓFe₅₋ₘGaₘO₁₂
where x and m are mole fractions of Gd and Ga, and wherein said has a set of values of x and m falling in the area encompassed by a polygon ABCDE defined by points A (0, 0), B (0.6, 0), C (1, 0.88), D (0.41, 1) and E (0, 0.09) in a phase diagram of a binary system shown Fig. 1 with x as abscissa and m as ordinate, except for those falling on the side AE of the polygon.

4. The magnetostatic wave device according to claim 2 wherein said magnetic garnet film is of a composition expressed by the general formula:
Y₃₋ₓGdₓFe₅₋ₙAlₙO₁₂
where x and n are mole fractions of Gd and Al, and wherein said composition has a set of values of x and n falling in the area encompassed by a polygon ABC'D'E' defined by points A (0, 0), B (0.60, 0), C' (1.00, 0.34), D' (1.00, 0.49) and E' (0, 0.02) in a phase diagram of a binary system shown Fig. 2 with x as abscissa and n as ordinate, except for those falling on the side AE' of the polygon.

5. The magnetostatic wave device according to claim 2 wherein said magnetic garnet film is of a composition expressed by the general formula:
Y₃₋ₓGdₓFe₅₋ₘ₋ₙGaₘAlₙO₁₂
where x, m and n are mole fractions of Gd, Ga and Al and wherein said composition has a set of values of x, m and n falling in the area encompassed by a polyhedron ABCDEFGH defined by points A (0, 0, 0), B (0.6, 0, 0), C (1, 0.88, 0), D (0.41, 1, 0), E (0, 0.09, 0), F (1, 0, 0.34), G (1, 0, 0.49) and H (0, 0, 0.02) in the Cartesian coordinate system shown in Fig. 3.

6. The magnetostatic wave device according to claim 2 wherein said magnetic garnet film is of a composition expressed by the general formula:
Y_{3-x-y}GdₓBi_{y}Fe₅O₁₂
where x and y are mole fractions of Gd and Bi and take a set of values in the following ranges: 0 < x ≦ 1, 0 ≦ y ≦ 1, 0 < x + y ≦ 1, and wherein said composition has a set of x and y falling within the area encompassed by a polygon ABC defined by points A (0, 0), B (0.6, 0), C (0, 0.23) in a compositional diagram shown in Fig. 4 with x as abscissa and y as ordinate, except for a set of values x and y falling on the side AC of the polygon ABC.

7. The magnetostatic wave device according to claim 2 wherein said magnetic garnet film is of a composition expressed by the general formula:
Y_{3-x-y}GdₓBi_{y}Fe₅₋ₘGaₘO₁₂
where x, y and m are mole fractions of Gd, Bi and Ga and take a set of values in the following respective ranges: 0 < x ≦ 1, 0 ≦ y ≦ 1, 0 < x + y ≦ 1, and 0 ≦ m < 1, and wherein said composition has a set of x, y and m falling within the area encompassed by a polyhedron ABCDEF defined by points A (0, 0, 0), B (0.6, 0, 0), C (0, 0.23, 0), D (0, 0.41, 1), E (0, 0.15, 1) and F (0, 0, 0.10) in the compositional diagram shown in Fig. 5.

8. The magnetostatic wave device according to claim 2 wherein said magnetic garnet film is of a composition expressed by the general formula:
Y_{3-x-y}GdₓBi_{y}Fe₅₋ₙAlₙO₁₂
where x, y and n are mole fractions of Gd, Bi and Al and take a set of values in the following ranges: 0 < x ≦ 1, 0 ≦ y ≦ 1, 0 < x + y ≦ 1, and 0 ≦ n ≦ 1, and wherein said composition has a set of x, y and n falling within the area encompassed by a polyhedron ABCDEF defined by points A (0, 0, 0), B (0.6, 0, 0), C (0, 0.23, 0), D (0, 1, 0.96), E (0, 0.79, 1) and F (0, 0, 0.02) in the compositional diagram shown in Fig. 6.
